# EUROPEAN PATENT APPLICATION

(11) **EP 4 697 227 A1**
(43) Date of publication of application: **18.02.2026**
(21) Application number: 24795808.5
(22) Date of filing: 07.04.2024
(51) Int. Cl.: G06F 30/392

(54) **INTEGRATED APPARATUS, COMMUNICATION CHIP AND COMMUNICATION DEVICE**

(30) Priority: 25.04.2023 CN 202310471779
(71) Applicant: Huawei Technologies Co., Ltd., Shenzhen, Guangdong 518129 (CN)
(72) Inventor: ZHANG, Xianfu, Shenzhen, Guangdong 518129 (CN); TU, Lei, Shenzhen, Guangdong 518129 (CN); GAO, Shan, Shenzhen, Guangdong 518129 (CN); SHAO, Liexiong, Shenzhen, Guangdong 518129 (CN)
(74) Representative: Maiwald GmbH
(86) International application number: PCT/CN2024/086375
(87) International publication number: WO 2024/222427

(57) **Abstract**

This application provides an integrated apparatus, a communication chip, and a communication device, and relates to the field of electronic technologies, to resolve a problem of line crossing existing when an interface of a die is connected to a corresponding side of a board. The integrated apparatus includes an interposer and a die located on the interposer, where the die includes a switching logic block, a line logic block, a first interface, and a second interface; the switching logic block is configured to control data exchange of the die; the line logic block is configured to control data receiving and sending of the die; the switching logic block is connected to the first interface via the interposer; and the line logic block is connected to the second interface via the interposer.

## Description

This application claims priority to Chinese Patent Application No. 202310471779.4, filed with the China National Intellectual Property Administration on April 25, 2023 and entitled "INTEGRATED APPARATUS, COMMUNICATION CHIP, AND COMMUNICATION DEVICE", which is incorporated herein by reference in its entirety.

### TECHNICAL FIELD

This application relates to the field of electronic technologies, and in particular, to an integrated apparatus, a communication chip, and a communication device.

### BACKGROUND

As a semiconductor process continues to advance to 3 nm or 2 nm, a size of a transistor is increasingly approaching a physical limit, resulting in increasing time and costs, and increasingly limited economic benefits. Against this backdrop, the industry places great expectations on a chiplet (chiplet). The chiplet is to disassemble an original complex chip into a group of dies (dies) with independent functions, and then interconnect and package the group of dies into a complete chip system by using a die-to-die (die-to-die) interconnection technology and a packaging technology.

Currently, when a chip includes a plurality of dies with a same function, the plurality of dies are usually packaged together in manners such as rotation and symmetrization. However, due to packaging in the manners such as rotation and symmetrization, a problem of line crossing exists when an interface of the die is connected to a corresponding side of a board. This affects chip logic, packaging, a board design, and the like to some extent, and further increases complexity of the chip.

### SUMMARY

This application provides an integrated apparatus, a communication chip, and a communication device, to resolve a problem of line crossing existing when an interface of a die is connected to a corresponding side of a board in the conventional technology.

To achieve the foregoing objectives, the following technical solutions are used in embodiments of this application.

According to a first aspect, an integrated apparatus is provided. The integrated apparatus includes an interposer and a die located on the interposer, where the die may be a logic die or a storage die; the die includes a switching logic block, a line logic block, a first interface, and a second interface; the switching logic block is configured to control data exchange of the die; the line logic block is configured to control data receiving and sending of the die; the switching logic block is connected to the first interface via the interposer; and the line logic block is connected to the second interface via the interposer.

In the foregoing technical solution, the switching logic block may be connected to the first interface via the interposer, and the line logic block may be connected to the second interface via the interposer, so that the switching logic block and the line logic block are connected to the first interface and the second interface of the die via the interposer. That is, compared with the conventional technology, in this application, different interfaces of a same die may be exchanged via the interposer, so that when the die is used in a chip, a problem of bus crossing in the conventional technology can be resolved. In addition, process requirements and costs of the interposer are far lower than process requirements and costs of the die, so that an area, costs, and power consumption of the die can be reduced when the bus crossing is implemented via the interposer.

In a possible implementation of the first aspect, the switching logic block is further connected to the second interface via the interposer, and the line logic block is further connected to the first interface via the interposer. In the foregoing possible implementation, two connection paths may be disposed for each of the first interface and the second interface of the die via the interposer. When the die is used in the chip, interfaces used by the switching logic block and the line logic block in the die may be properly configured based on locations of the first interface and the second interface, so that a problem of bus crossing does not exist when the chip in which the die is used is connected to a line side and a fabric side of a board.

In a possible implementation of the first aspect, the first interface is configured to connect to an optical transport unit, the second interface is configured to connect to a switching unit, the switching logic block is configured to exchange data through the first interface, and the line logic block is configured to receive and send data through the second interface. Alternatively, the first interface is configured to connect to a switching unit, the second interface is configured to connect to an optical transport unit, the switching logic block is configured to exchange data through the second interface, and the line logic block is configured to receive and send data through the first interface. In the foregoing possible implementation, the interfaces used by the switching logic block and the line logic block in the die are properly configured, so that a problem of bus crossing does not exist when the chip in which the die is used is connected to the line side and the fabric side of the board.

In a possible implementation of the first aspect, the interposer includes a redistribution layer, and the redistribution layer is configured to connect the switching logic block and the line logic block to the first interface and the second interface. In the foregoing possible implementation, the switching logic block and the line logic block are connected to the first interface and the second interface via the redistribution layer, so that an area, costs, and power consumption of the die can be reduced.

In a possible implementation of the first aspect, the die further includes an active component, and the active component is further configured to connect the switching logic block and the line logic block to the first interface and the second interface; or the redistribution layer includes an active component, and the active component is further configured to connect the switching logic block and the line logic block to the first interface and the second interface. Optionally, the active component may include but is not limited to a register, a multiplexer MUX, a NAND gate NAND, a NOT gate NOR, and the like. In the foregoing possible implementation, the switching logic block and the line logic block are connected to the first interface and the second interface via the active component and the redistribution layer, and the active component may be configured to enhance performance of a data signal transmitted in the foregoing connection, to dispose a long-distance connection trace.

In a possible implementation of the first aspect, the integrated apparatus further includes a substrate, and the interposer is integrated on the substrate in an embedded manner. In the foregoing possible implementation, the interposer is integrated on the substrate in an embedded manner. This can reduce costs and an area of the integrated apparatus.

In a possible implementation of the first aspect, the interposer is of a multi-layer structure. In the foregoing possible implementation, when the interposer is of the multi-layer structure, a plurality of layers in the multi-layer structure may be configured to connect the switching logic block to the first interface and connect the line logic block to the second interface, or may be configured to connect the switching logic block to the second interface and connect the line logic block to the first interface, to further meet long-distance and high-complexity connection and wiring.

According to a second aspect, a communication chip is provided. The communication chip includes the integrated apparatus in any one of the first aspect or the possible implementations of the first aspect.

According to a third aspect, a communication chip is provided. The communication chip includes an interposer and a plurality of dies located on the interposer. The plurality of dies include a first die and a second die, the first die includes a first logic block and a first interface, the second die includes a second logic block and a second interface, the first logic block of the first die is connected to the second interface of the second die via the interposer, and the second logic block of the second die is connected to the first interface of the first die via the interposer. The first logic block is one of a switching logic block and a line logic block, and the second logic block is the other of the switching logic block and the line logic block. A switching logic block in each die is configured to control data exchange of the die, and a line logic block in each die is configured to control data receiving and sending of the die.

In a possible implementation of the third aspect, the first die further includes a second logic block and a second interface that are connected to each other, and the second die further includes a first logic block and a first interface that are connected to each other.

In a possible implementation of the third aspect, if the first logic block is the switching logic block, the first interface and the second interface of the second die are configured to connect to a switching unit, and the first interface and the second interface of the first die are configured to connect to an optical transport unit; or if the second logic block is the switching logic block, the first interface and the second interface of the first die are configured to connect to a switching unit, and the first interface and the second interface of the second die are configured to connect to an optical transport unit.

In a possible implementation of the third aspect, the interposer includes a redistribution layer, and the redistribution layer is configured to connect the first logic block of the first die to the second interface of the second die and connect the second logic block of the second die to the first interface of the first die.

In a possible implementation of the third aspect, the first die and the second die further include active components, and the active components are further configured to connect the first logic block of the first die to the second interface of the second die and connect the second logic block of the second die to the first interface of the first die; or the redistribution layer includes an active component, and the active component is further configured to connect the first logic block of the first die to the second interface of the second die and connect the second logic block of the second die to the first interface of the first die.

In a possible implementation of the third aspect, the communication chip further includes a substrate, and the interposer is integrated on the substrate in an embedded manner.

In a possible implementation of the third aspect, the interposer is of a multi-layer structure.

According to a fourth aspect, a communication device is provided. The communication device includes a switching unit and a line processing unit connected to the switching unit, and the line processing unit includes the communication chip provided in any one of the second aspect, the third aspect, or the possible implementations of the third aspect.

According to a fifth aspect, an integrated apparatus is provided. The integrated apparatus includes an interposer and a die located on the interposer. The die includes a first unit and a second unit, the first unit includes a first logic block and a first interface, the second unit includes a second logic block and a second interface, the first logic block of the first unit is connected to the second interface of the second unit via the interposer, and the second logic block of the second unit is connected to the first interface of the first unit via the interposer. The first logic block is one of a switching logic block and a line logic block, and the second logic block is the other of the switching logic block and the line logic block. A switching logic block in each unit is configured to control data exchange of the unit, and a line logic block in each unit is configured to control data receiving and sending of the unit.

In a possible implementation of the fifth aspect, the first unit further includes a second logic block and a second interface that are connected to each other, and the second unit further includes a first logic block and a first interface that are connected to each other.

In a possible implementation of the fifth aspect, if the first logic block is the switching logic block, the first interface and the second interface of the second unit are configured to connect to a switching unit; or if the second logic block is the switching logic block, the first interface and the second interface of the first unit are configured to connect to a switching unit.

In a possible implementation of the fifth aspect, the interposer includes a redistribution layer, and the redistribution layer is configured to connect the first logic block of the first unit to the second interface of the second unit and connect the second logic block of the second unit to the first interface of the first unit.

In a possible implementation of the fifth aspect, the first unit and the second unit further include active components, and the active components are further configured to connect the first logic block of the first unit to the second interface of the second unit and connect the second logic block of the second unit to the first interface of the first unit; or the redistribution layer includes an active component, and the active component is further configured to connect the first logic block of the first unit to the second interface of the second unit and connect the second logic block of the second unit to the first interface of the first unit.

In a possible implementation of the fifth aspect, the integrated apparatus further includes a substrate, and the interposer is integrated on the substrate in an embedded manner.

In a possible implementation of the fifth aspect, the interposer is of a multi-layer structure.

According to a sixth aspect, a communication chip is provided. The communication chip includes the integrated apparatus in any one of the fifth aspect or the possible implementations of the fifth aspect.

According to a seventh aspect, a communication device is provided. The communication device includes a switching unit and a line processing unit connected to the switching unit, and the line processing unit includes the communication chip provided in the sixth aspect.

It may be understood that, for beneficial effect that can be achieved by any one of the communication chip, the integrated apparatus, and the communication device provided above, correspondingly refer to the beneficial effect of the integrated apparatus provided in the first aspect provided above. Details are not described herein again.

### BRIEF DESCRIPTION OF DRAWINGS

FIG. 1 is a diagram of a structure of a chip based on a chiplet technology according to an embodiment of this application;
FIG. 2 is a diagram of a structure of an NP chip obtained through die packaging;
FIG. 3 is a diagram of a connection between an NP chip and a board;
FIG. 4 is a diagram of a structure for resolving bus crossing of an NP chip;
FIG. 5 is a diagram of another connection between an NP chip and a board;
FIG. 6 is a diagram of a structure of an integrated apparatus according to an embodiment of this application;
FIG. 7 is a diagram of another structure of an integrated apparatus according to an embodiment of this application;
FIG. 8 is a diagram of another structure of an integrated apparatus according to an embodiment of this application;
FIG. 9 is a diagram of another structure of an integrated apparatus according to an embodiment of this application;
FIG. 10 is a diagram of another structure of an integrated apparatus according to an embodiment of this application;
FIG. 11 is a diagram of another structure of an integrated apparatus according to an embodiment of this application;
FIG. 12 is a diagram of a structure of a communication chip according to an embodiment of this application;
FIG. 13 is a diagram of another structure of a communication chip according to an embodiment of this application;
FIG. 14 is a diagram of another structure of a communication chip according to an embodiment of this application;
FIG. 15 is a diagram of another structure of an integrated apparatus according to an embodiment of this application;
FIG. 16 is a diagram of another structure of a communication chip according to an embodiment of this application;
FIG. 17 is a diagram of another structure of a communication chip according to an embodiment of this application;
FIG. 18 is a diagram of another structure of a communication chip according to an embodiment of this application;
FIG. 19 is a diagram of another structure of an integrated apparatus according to an embodiment of this application;
FIG. 20 is a diagram of another structure of an integrated apparatus according to an embodiment of this application; and
FIG. 21 is a diagram of a structure of a communication device according to an embodiment of this application.

### DESCRIPTION OF EMBODIMENTS

Making and using of embodiments are discussed in detail below. It should be appreciated, however, that a plurality of applicable inventive concepts provided in this application may be implemented in a plurality of specific environments. The specific embodiments discussed are merely illustrative of specific ways to implement and use this description and this technology, and do not limit the scope of this application.

Unless otherwise defined, all technical terms used herein have same meanings as those commonly known to a person of ordinary skill in the art.

Circuits or other components may be described as or referred to as "configured to" perform one or more tasks. In this case, the term "configured to" is used for implying a structure by indicating that a circuit/component includes a structure (for example, a circuit system) that performs one or more tasks during operation. Therefore, even when a specified circuit/component is currently not operable (for example, not turned on), the circuit/component may also be referred to as being configured to perform the task. Circuits/components used in conjunction with the "configured to" phrase include hardware, for example, a circuit for performing an operation.

The following describes the technical solutions in embodiments of this application with reference to accompanying drawings in embodiments of this application. In this application, "at least one" means one or more, and "a plurality of" means two or more. The term "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one item (piece) of a, b, or c may represent: a, b, c, a and b, a and c, b and c, or a, b, and c, where a, b, and c may be singular or plural. In addition, in embodiments of this application, terms such as "first" and "second" do not limit a quantity or an execution sequence.

In this application, the term "example", "for example", or the like is used to give an example, an illustration, or a description. Any embodiment or design scheme described as an "example" or "for example" in this application should not be explained as having more advantages than another embodiment or design scheme. Exactly, use of the word such as "example" or "for example" is intended to present a related concept in a specific manner. "Coupling" in this application may be understood as a direct connection or an indirect connection. For example, coupling A to B may represent that A is directly connected to B, or that A is indirectly connected to B.

Before embodiments of this application are described below, content of the related background in embodiments of this application are first described.

As a semiconductor process continues to advance to 3 nm or 2 nm, a size of a transistor is approaching a physical limit, resulting in increasing time and costs, and increasingly limited economic benefits. Against this backdrop, the industry places great expectations on a chiplet (chiplet), that is, expects to bring better economic benefits by using a chiplet technology while keeping costs unchanged.

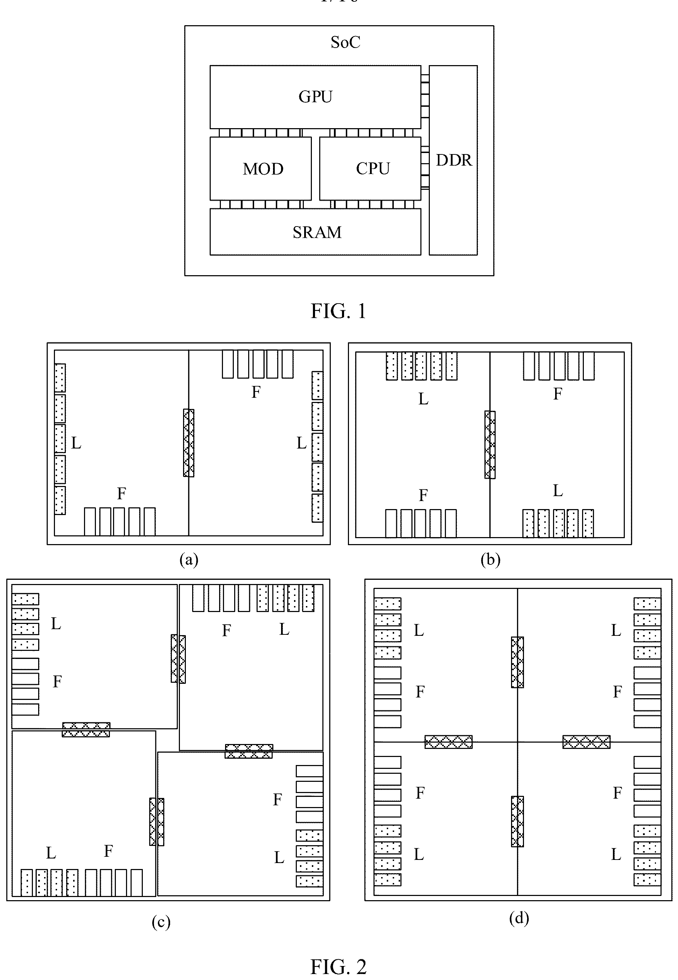

The chiplet is to disassemble an original complex chip into a group of dies (dies) with independent functions, and then interconnect and package the group of dies into a complete chip by using a die-to-die (die-to-die) interconnection technology and a packaging technology. The chip may also be referred to as a chip system (system of chip, SoC). For example, as shown in FIG. 1, it is assumed that a group of dies include a graphics processing unit (graphics processing unit, GPU), a modem (modem, MOD), a central processing unit (central processing unit, CPU), a static random access memory (static random-access memory, SRAM), and a double data rate (double data rate, DDR) memory (DDR for short). The GPU, the MOD, the CPU, the SRAM, and the DDR may be interconnected by using the die-to-die interconnection technology, and then packaged by using the packaging technology, to obtain a complete chip system (SoC).

Currently, when a chip includes a plurality of dies with a same function, the plurality of dies are usually packaged together in manners such as rotation and symmetrization. The following uses an example in which a network processing (network processing, NP) chip is obtained through die packaging for description. The NP chip may be usually used in a switch or a router. The NP chip may include a line side (line side) interface and a fabric side (fabric side) interface. The line side interface may be represented as an L interface, and the fabric side interface may be represented as an F interface.

The NP chip may include at least two dies, and the at least two dies may be packaged together in manners such as rotation and symmetrization. In a possible example, the NP chip may include two dies, an L interface and an F interface are disposed on two adjacent sides of each of the two dies, and the two dies may be packaged together in a manner shown in (a) in FIG. 2. In another possible example, the NP chip may include two dies, an L interface and an F interface are disposed on two opposite sides of each of the two dies, and the two dies may be packaged together in a manner shown in (b) in FIG. 2. In a possible example, the NP chip may include four dies, an L interface and an F interface are disposed on one side of each of the four dies, and the four dies may be packaged together in a manner shown in (c) in FIG. 2. In another possible example, the NP chip may include four dies, an L interface and an F interface are disposed on one side of each of the four dies, and the four dies may be packaged together in a manner shown in (d) in FIG. 2.

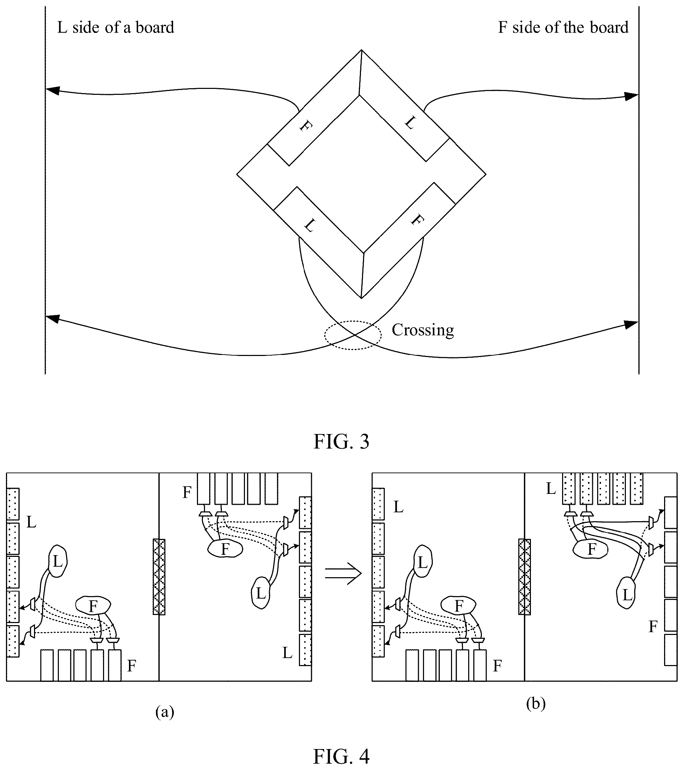

However, due to packaging in the manners such as rotation and symmetrization, a problem of line crossing exists when an interface of the chip is connected to a corresponding side of a board. This affects chip logic, packaging, a board design, and the like to some extent, and further increases complexity of the chip. For example, as shown in FIG. 3, an NP chip is obtained through die packaging, and a line side interface and a fabric side interface are respectively disposed on two adjacent sides of the NP chip. When an L interface and an F interface of the NP chip are connected to a corresponding line side and fabric side of the board, connection buses corresponding to the two interfaces have a problem of bus crossing. In FIG. 3, the line side of the board is represented as an L side of the board, and the fabric side of the board is represented as an F side of the board.

In a related technology, a manner of switching the two types of interfaces inside the die is usually used to resolve the problem of bus crossing. Specifically, two connection paths are disposed inside the die for each of the two types of interfaces, the two connection paths may be selectively connected to one of two types of logic blocks in the die, and the two types of logic blocks may include a line logic block (represented as an L logic block) and a switching logic block (represented as an F logic block).

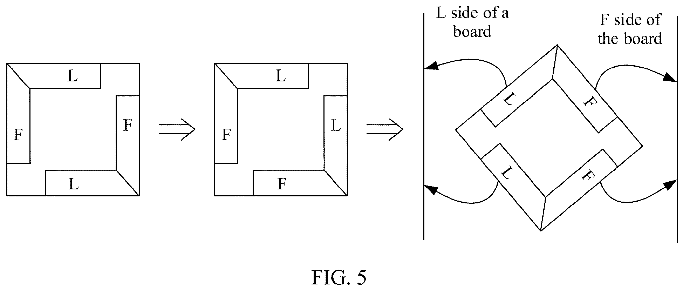

For example, the NP chip is obtained by packaging two dies. When each L logic block in the two dies is connected to a corresponding interface on a first side, and each F logic block in the two dies is connected to a corresponding interface on a second side, distribution of L interfaces and F interfaces of the NP chip is shown in (a) in FIG. 4. When an L logic block of one die in the two dies is connected to an interface on a first side of the one die, an F logic block of the one die is connected to an interface on a second side of the one die, an L logic block of the other die is connected to an interface on a second side of the other die, and an F logic block of the other die is connected to an interface on a first side of the other die, distribution of L interfaces and F interfaces of the NP chip is shown in (b) in FIG. 4. Correspondingly, as shown in FIG. 5, an L interface and an F interface on two adjacent sides of the NP chip are converted into two L interfaces or two F interfaces. In this way, a problem of bus crossing does not exist when the L interface and the F interface of the NP chip are connected to a corresponding line side and fabric side of a board.

However, when two connection paths are disposed in each die of a chip for each of the two types of interfaces, a large quantity of traces and related logic components need to be disposed, resulting in occupation of an area in the die, an increase in die costs, and high power consumption.

In addition, in the related technology, a board-level bus crossing manner, that is, a manner of deploying cables or traces on the board is usually used to resolve the problem that the connection buses corresponding to the two types of interfaces cross each other. However, board-level bus crossing is limited by a package insertion loss, and cannot support long-bus crossing. In addition, deployment of a large quantity of traces increases a quantity of layers of the board. This further increases a design difficulty and costs of the board.

In view of this, embodiments of this application provide an integrated apparatus, a communication chip, and a communication device. The integrated apparatus includes an interposer (interposer) and a die located on the interposer. A switching logic block and a line logic block are connected to a first interface and a second interface of the die via the interposer, to resolve the foregoing problem of bus crossing. In addition, process requirements and costs of the interposer are far lower than process requirements and costs of the die, so that an area, costs, and power consumption of the die can be reduced when the bus crossing is implemented via the interposer. The following describes the technical solutions in embodiments of this application.

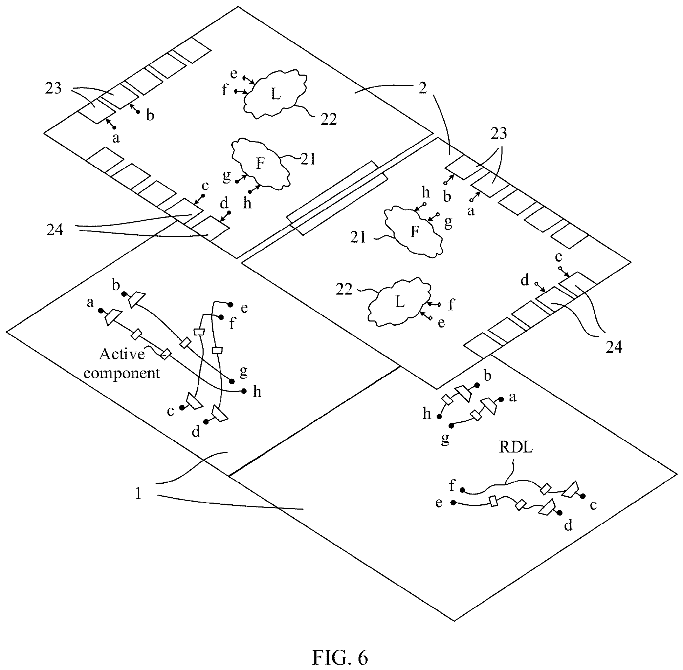

FIG. 6 is a diagram of a structure of an integrated apparatus according to an embodiment of this application. The integrated apparatus includes an interposer 1 and a die 2 located on the interposer 1. The die 2 includes a switching logic block 21, a line logic block 22, a first interface 23, and a second interface 24. The switching logic block 21 is configured to control data exchange of the die 2. The line logic block 22 is configured to control data receiving and sending of the die 2. The switching logic block 21 is connected to the first interface 23 via the interposer 1, and the line logic block 22 is connected to the second interface 24 via the interposer 1. In FIG. 6, the switching logic block 21 is represented as F, the line logic block 22 is represented as L, and connection points (for example, solder joints) that correspond to the first interface 23, the second interface 24, the switching logic block 21, and the line logic block 22 and that are in the interposer 1 and the die 2 are sequentially represented as a and b, c and d, e and f, and g and f. In addition, an example in which two dies 2 are interconnected is used for description.

The die 2 may also be referred to as a bare die or a die, and the die 2 may be obtained by cutting a wafer (wafer). Optionally, the die 2 may be any die that has at least two types of interfaces and that has a problem of bus crossing when being connected to a board. In this specification, an example in which the die 2 has two types of interfaces is used for description. The first interface 23 and the second interface 24 may be two types of interfaces of the die 2. The two types of interfaces may be located on a same side of the die, or may be located on different sides of the die. The die 2 may include one or more first interfaces 23, and may further include one or more second interfaces 24. This is not specifically limited in embodiments of this application. The die 2 may be a logic die, or may be a storage die. In a possible example, the die 2 may be an NP die (or referred to as an NP die), and two types of interfaces of the NP die may include a line side interface and a fabric side interface.

In addition, the switching logic block 21 is configured to control data exchange of the die 2. In other words, the switching logic block 21 is configured to control a data exchange path during data exchange of the die 2, for example, control data exchange between the die 2 and a switching unit (switching unit, SWU). The switching logic block 21 may be specifically connected to one or more interfaces of the die 2. When the switching logic block 21 is connected to the one or more interfaces, the one or more interfaces may be referred to as fabric side interfaces (which may be specifically configured to connect to the switching unit), and the switching logic block 21 may control data of the die 2 to be exchanged to the corresponding fabric side interface. For example, the switching unit and the integrated apparatus may be disposed independently of each other, or the switching unit and the integrated apparatus may be disposed on a same board, a same device, or the like. Optionally, the switching unit may be a switching chip, a switching board, a switching subrack, or the like.

The line logic block 22 is configured to control data receiving and sending of the die 2. The data receiving may be receiving data from an optical module, and the data sending may be sending data to the optical module. To be specific, the line logic block 22 is configured to control the die 2 to receive the data from the optical module and send the data to the optical module. The line logic block 22 may be specifically connected to one or more interfaces of the die 2. When the line logic block 22 is connected to the one or more interfaces, the one or more interfaces may be referred to as line side interfaces (which may be specifically configured to connect to an optical transport unit), and the line logic block 22 may control the die 2 to send and receive data through the line side interface. For example, the optical transport unit and the integrated apparatus may be disposed independently of each other, or the optical transport unit and the integrated apparatus may be disposed on a same board, a same device, or the like. Optionally, the optical transport unit may be the optical module.

In this embodiment of this application, the switching logic block 21 may be connected to the first interface 23 via the interposer 1, and the line logic block 22 may be connected to the second interface 24 via the interposer 1, so that the switching logic block 21 and the line logic block 22 are connected to the first interface 23 and the second interface 24 of the die 2 via the interposer 1. That is, compared with the conventional technology, in this application, different interfaces of a same die may be exchanged via the interposer 1, so that when the die 2 is used in a chip, a problem of bus crossing in the conventional technology can be resolved. In addition, process requirements and costs of the interposer 1 are far lower than process requirements and costs of the die 2, so that an area, costs, and power consumption of the die 2 can be reduced when the bus crossing is implemented via the interposer 1.

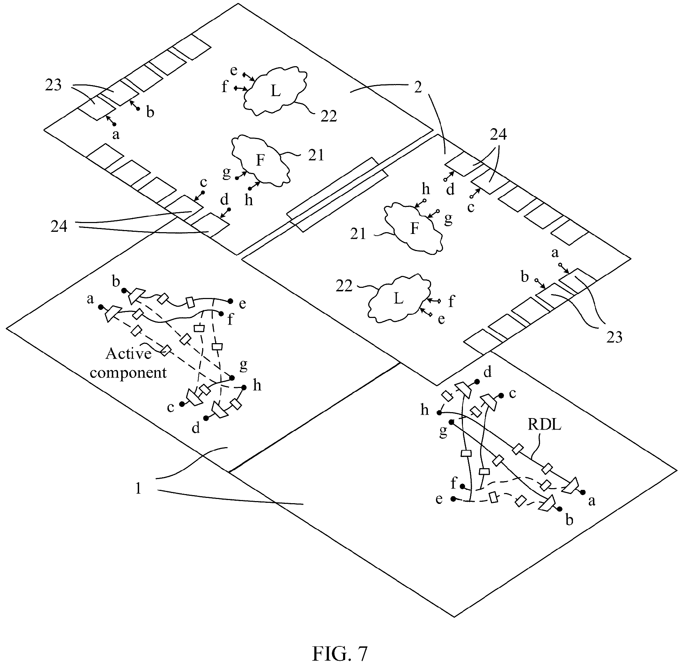

Further, with reference to FIG. 6, as shown in FIG. 7, the switching logic block 21 is further connected to the second interface 24 via the interposer 1, and the line logic block 22 is further connected to the first interface 23 via the interposer 1. That is, the switching logic block 21 may be separately connected to the first interface 23 and the second interface 24 via the interposer 1, and the line logic block 22 may also be separately connected to the first interface 23 and the second interface 24 via the interposer 1.

Specifically, the switching logic block 21 is configured to exchange data through one of the first interface 23 and the second interface 24, and the line logic block 22 is configured to receive and send data through the other of the first interface 23 and the second interface 24. For example, the switching logic block 21 is configured to exchange data through the first interface 23, and the line logic block 22 is configured to receive and send data through the second interface 24; or the switching logic block 21 is configured to exchange data through the second interface 24, and the line logic block 22 is configured to receive and send data through the first interface 23.

In actual application, a first selector switch may be disposed in a connection of the first interface 23, a fastening end of the first selector switch is connected to the first interface 23, and two selection ends of the first selector switch may be respectively connected to the switching logic block 21 and the line logic block 22. In this way, interfaces used by the switching logic block 21 and the line logic block 22 can be configured by configuring the two selection ends of the first selector switch. Similarly, a second selector switch may be disposed in a connection of the second interface 24, a fastening end of the second selector switch is connected to the second interface 24, and two selection ends of the second selector switch may be respectively connected to the switching logic block 21 and the line logic block 22. In this way, interfaces used by the switching logic block 21 and the line logic block 22 can be configured by configuring the two selection ends of the second selector switch.

In this embodiment of this application, two connection paths may be disposed for each of the first interface 23 and the second interface 24 of the die 2 via the interposer 1. When the die 2 is used in the chip, interfaces used by the switching logic block 21 and the line logic block 22 in the die 2 may be properly configured based on locations of the first interface 23 and the second interface 24, so that a problem of bus crossing does not exist when the chip in which the die 2 is used is connected to a line side and a fabric side of the board.

In addition, in this embodiment of this application, when the die 2 is used in the chip, the chip may include one or more dies 2. The one or more dies 2 may be packaged through interconnection, to obtain the chip; or may be packaged with another die through interconnection, to obtain the chip. For a same chip, a connection between the switching logic block 21 and the first interface 23 and the second interface 24 of the die 2 and a connection between the line logic block 22 and the first interface 23 and the second interface 24 of the die 2 may be fastened, or are configurable. This is not specifically limited in embodiments of this application.

Further, in a possible embodiment, the interposer 1 may be an active interposer (active interposer). In a possible example, as shown in FIG. 6 or FIG. 7, the interposer 1 may include a redistribution layer (re-distributed layer, RDL), and the redistribution layer (RDL) includes an active component. The redistribution layer (RDL) and the active component may be configured to connect the switching logic block 21 and the line logic block 22 to the first interface 23 and the second interface 24. For example, the redistribution layer (RDL) and the active component may be configured to connect the switching logic block 21 to the first interface 23 and connect the line logic block 22 to the second interface 24, and may further be configured to connect the switching logic block 21 to the second interface 24 and connect the line logic block 22 to the first interface 23.

Optionally, the active component may include but is not limited to a register, a multiplexer MUX, a NAND gate NAND, a NOT gate NOR, and the like. When the interposer 1 is the active interposer, the switching logic block 21 and the line logic block 22 may be connected to the first interface 23 and the second interface 24 via the active component and the redistribution layer (RDL) in the active interposer, and the active component may be configured to enhance performance of a data signal transmitted in the foregoing connection, to dispose a long-distance connection trace.

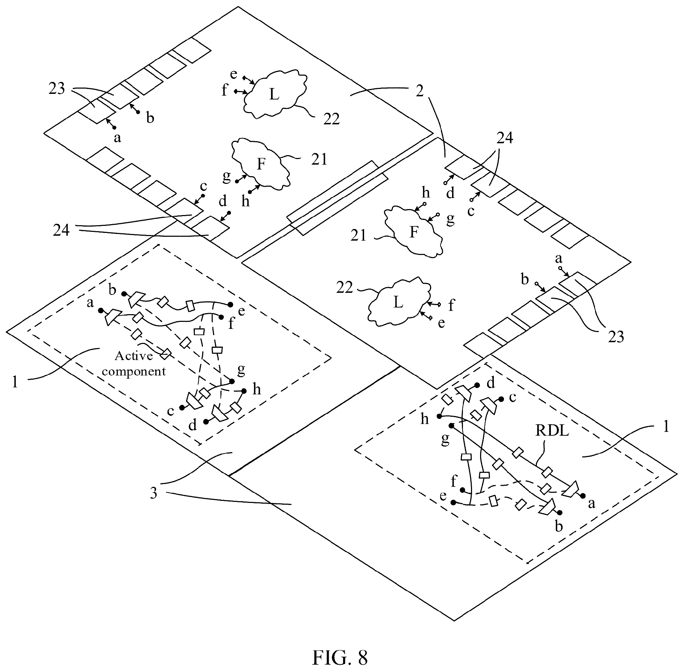

Optionally, as shown in FIG. 8, the integrated apparatus may further include a substrate 3, and the interposer 1 is integrated on the substrate 3 in an embedded (embedded) manner. When the interposer 1 is integrated on the substrate 3 in the embedded manner, the interposer 1 and the substrate 3 may be collectively referred to as an embedded bridge (embedded bridge). In FIG. 8, an example in which two dies 2 are interconnected is used for description.

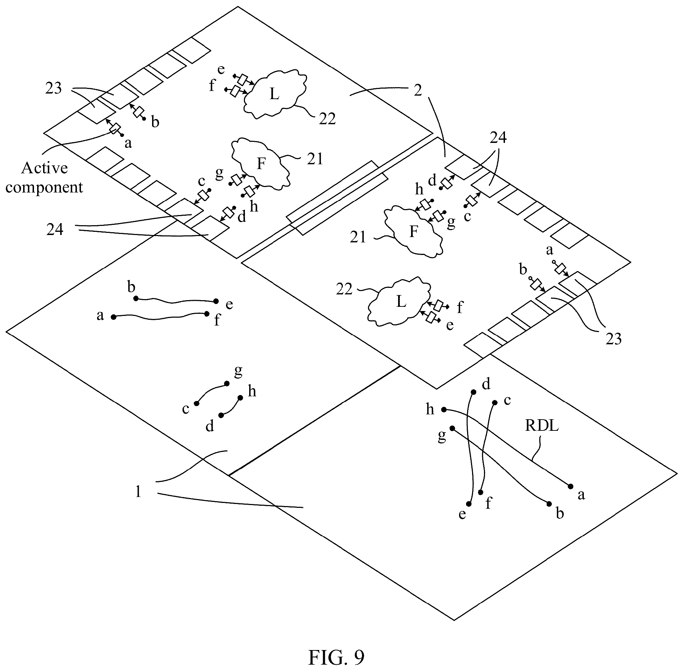

Further, in another possible embodiment, the interposer 1 may be a passive interposer (passive interposer). In a possible example, as shown in FIG. 9, the die 2 further includes an active component, the interposer 1 may include a redistribution layer (RDL), and the active component and the redistribution layer (RDL) may be configured to connect the switching logic block 21 and the line logic block 22 to the first interface 23 and the second interface 24. For example, the active component and the redistribution layer (RDL) may be configured to connect the switching logic block 21 to the first interface 23 and connect the line logic block 22 to the second interface 24, and may further be configured to connect the switching logic block 21 to the second interface 24 and connect the line logic block 22 to the first interface 23.

Optionally, the active component may include but is not limited to a register, a multiplexer MUX, a NAND gate NAND, a NOT gate NOR, and the like. When the interposer 1 is the passive interposer, the switching logic block 21 and the line logic block 22 may be connected to the first interface 23 and the second interface 24 via the active component in the die 2 and the redistribution layer (RDL) in the passive interposer, and the active component may be configured to enhance performance of a data signal transmitted in the foregoing connection, to dispose a long-distance connection trace.

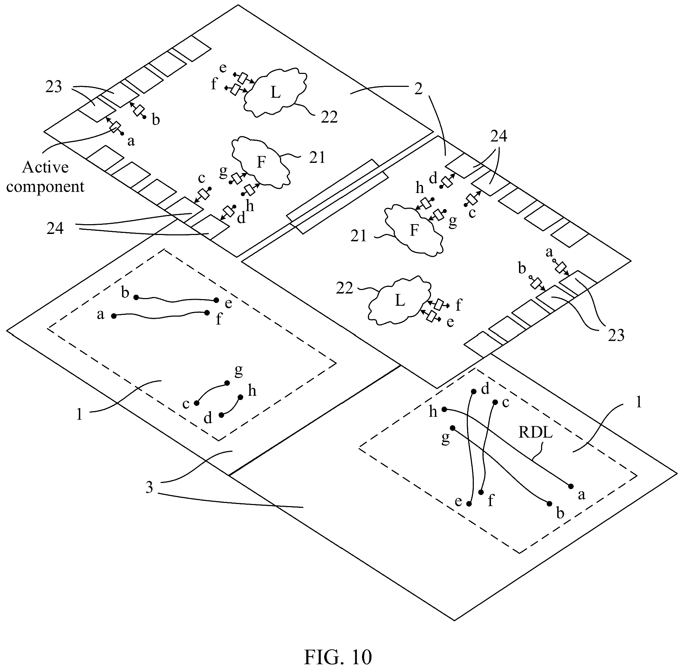

Optionally, with reference to FIG. 9, as shown in FIG. 10, the integrated apparatus may further include a substrate 3, and the interposer 1 is integrated on the substrate 3 in an embedded (embedded) manner. When the interposer 1 is integrated on the substrate 3 in the embedded manner, the interposer 1 and the substrate 3 may be collectively referred to as an embedded bridge (embedded bridge). In FIG. 9 and FIG. 10, an example in which two dies 2 are interconnected is used for description.

Further, the interposer 1 may be of a one-layer or multi-layer structure. When the interposer 1 is of the multi-layer structure, a plurality of layers in the multi-layer structure may be configured to connect the switching logic block 21 to the first interface 23 and connect the line logic block 22 to the second interface 24, and may further be configured to connect the switching logic block 21 to the second interface 24 and connect the line logic block 22 to the first interface 23.

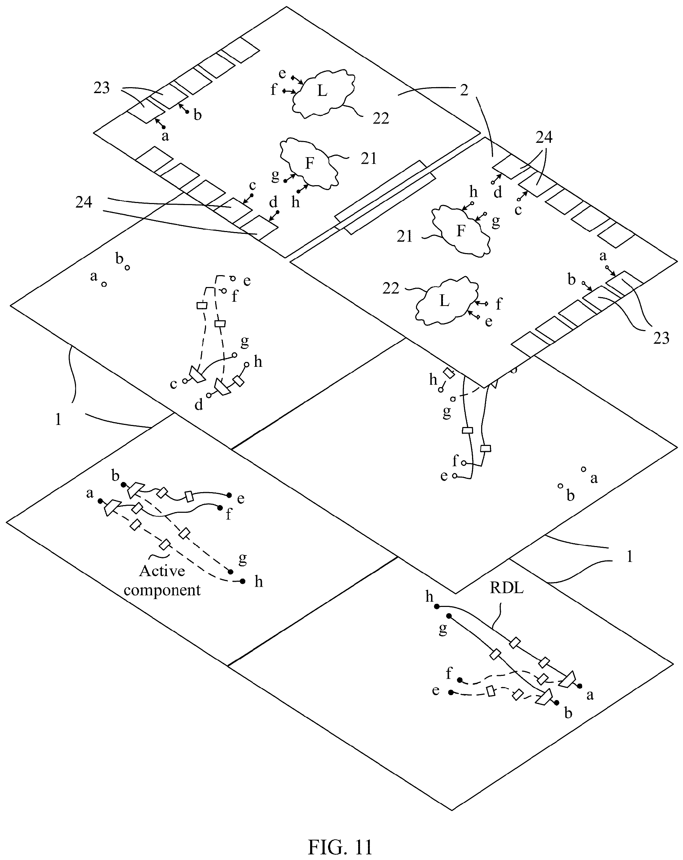

For example, as shown in FIG. 11, the interposer 1 may be of a two-layer structure, and the switching logic block 21 and the line logic block 22 may be connected to the first interface 23 and the second interface 24 via active components and redistribution layer layers (RDL) on two layers in the two-layer structure. For example, the switching logic block 21 is connected to the first interface 23. The switching logic block 21 may be first connected to an active component and a redistribution layer (RDL) on a first layer in the two-layer structure, and then connected to an active component and a redistribution layer (RDL) on a second layer, and the active component and the redistribution layer (RDL) on the second layer are connected to a solder joint (solder joint) that corresponds to the first interface 23 and that is on the second layer.

In FIG. 11, for example, the interposer 1 is an active interposer. When the interposer 1 is of the multi-layer structure, an example in which the switching logic block 21 and the line logic block 22 are connected to the first interface 23 and the second interface 24 via the multi-layer structure is used for description. When the interposer 1 is a passive interposer, and the interposer 1 is of the multi-layer structure, the foregoing connection may still be implemented via the multi-layer structure of the passive interposer. Details are not described herein again in embodiments of this application.

In view of this, an embodiment of this application further provides a communication chip. The communication chip may include one or more dies. The die may be a die that is provided above and that implements interface switching via an interposer 1. The interposer 1 corresponding to the plurality of dies may be one or more interposers. This is not specifically limited in embodiments of this application. The following describes several possible structures of the communication chip by using examples.

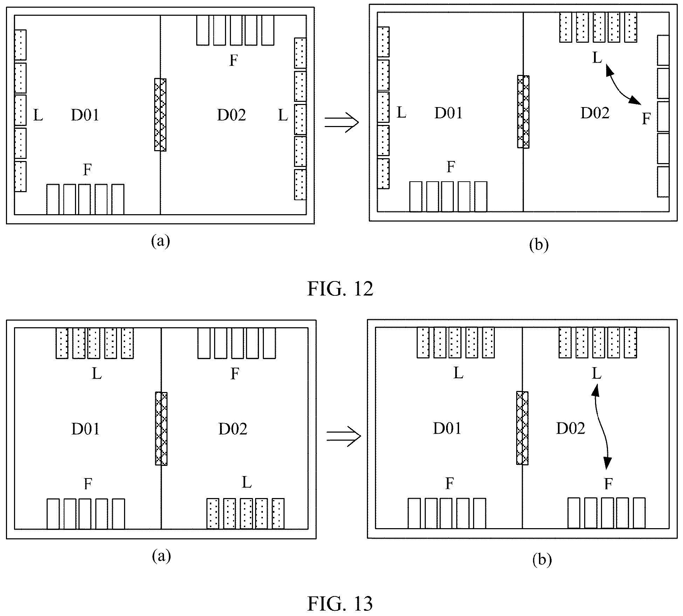

In a possible example, the communication chip may include two dies (represented as D01 and D02), and each die may include an L interface and an F interface that are disposed on two adjacent sides. When a solution in the conventional technology is used, the communication chip formed by packaging the two dies through rotation is shown in (a) in FIG. 12. When the technical solution in this embodiment of this application is used, in the two dies, a first die D01 may be a die in the conventional technology, and a second die D02 may be a die that is obtained by exchanging locations of the L interface and the F interface and that is provided in this embodiment of this application. In this case, the communication chip formed by packaging the two dies through rotation is shown in (b) in FIG. 12.

In another possible example, the communication chip may include two dies (represented as D01 and D02), and each die may include an L interface and an F interface that are disposed on two opposite sides. When a solution in the conventional technology is used, the communication chip formed by packaging the two dies through rotation is shown in (a) in FIG. 13. When the technical solution in this embodiment of this application is used, in the two dies, a first die D01 may be a die in the conventional technology, and a second die D02 may be a die that is obtained by exchanging locations of the L interface and the F interface and that is provided in this embodiment of this application. In this case, the communication chip formed by packaging the two dies through rotation is shown in (b) in FIG. 13.

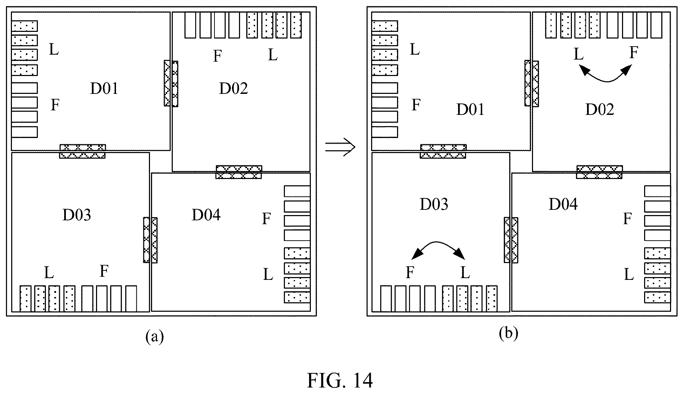

In still another possible example, the communication chip may include four dies (represented as D01 to D04), and each die may include an L interface and an F interface that are disposed on a same side. When a solution in the conventional technology is used, the communication chip formed by packaging the four dies through rotation is shown in (a) in FIG. 14. When the technical solution in this embodiment of this application is used, in the four dies, a first die D01 and a fourth die D04 may be dies in the conventional technology, and a second die D02 and third die D03 may be dies that are obtained by exchanging locations of the L interface and the F interface and that are provided in this embodiment of this application. In this case, the communication chip formed by packaging the four dies through rotation is shown in (b) in FIG. 14.

In the communication chip provided in this embodiment of this application, two types of different interfaces of a same die in the communication chip may be exchanged via the interposer 1, to resolve a problem of bus crossing existing when the communication chip is connected to a board in the conventional technology. In addition, process requirements and costs of the interposer 1 are far lower than process requirements and costs of the die, so that an area, costs, and power consumption of the communication chip can be reduced when the bus crossing is implemented via the interposer 1.

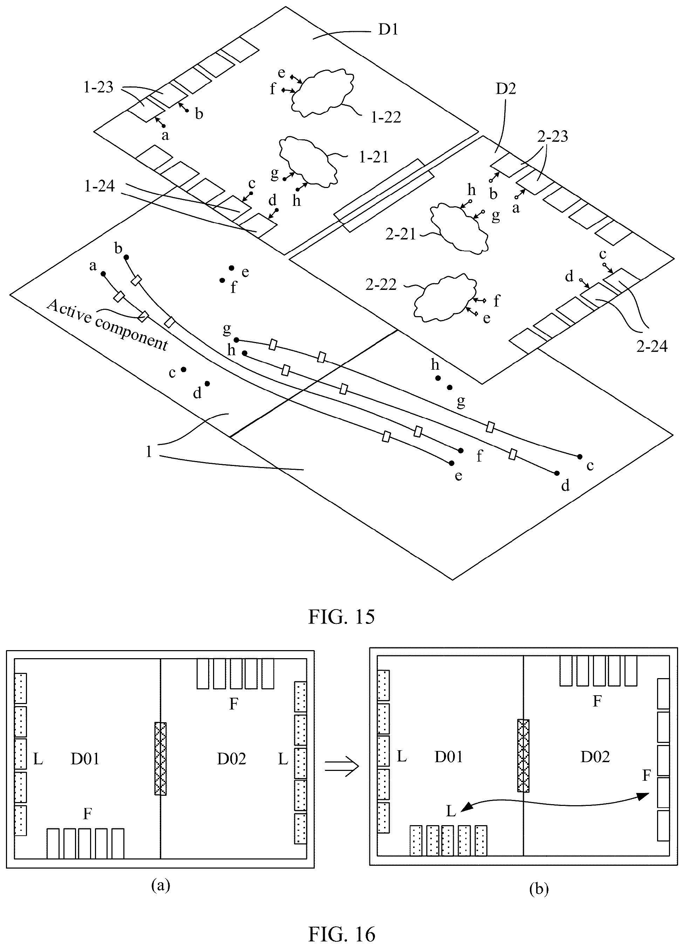

FIG. 15 is a diagram of a structure of a communication chip according to an embodiment of this application. The communication chip includes an interposer 1 and a plurality of dies located on the interposer 1, and the plurality of dies include a first die D1 and a second die D2. The first die D1 includes a first logic block 1-21 and a first interface 1-23, and the second die D2 includes a second logic block 2-22 and a second interface 2-24. The first logic block 1-21 of the first die D1 is connected to the second interface 2-24 of the second die D2 via the interposer 1, and the second logic block 2-22 of the second die D2 is connected to the first interface 1-23 of the first die D1 via the interposer 1.

Optionally, the first die D1 further includes a second logic block 1-22 and a second interface 1-24 that are connected to each other, and the second die D2 further includes a first logic block 2-21 and a first interface 2-23 that are connected to each other. In FIG. 15, descriptions are provided by using an example in which solder joints that correspond to the first interfaces (for example, 1-23 and 2-23), the second interfaces (for example, 1-24 and 2-24), the first logic blocks (for example, 1-21 and 2-21), and the second logic blocks (for example, 1-22 and 2-22) and that are in the interposer 1 and the die 2 are sequentially represented as a and b, c and d, e and f, and g and f.

In an example, the second logic block 1-22 may be connected to the second interface 1-24 inside the first die D1, and the first logic block 2-21 may be connected to the first interface 2-23 inside the second die D2. In another example, the second logic block 1-22 may alternatively be connected to the second interface 1-24 via the interposer 1, and the first logic block 2-21 may alternatively be connected to the first interface 2-23 via the interposer 1.

The first logic block (for example, 1-21 and 2-21) is one of a switching logic block and a line logic block, and the second logic block (for example, 1-22 and 2-22) is the other of the switching logic block and the line logic block; and a switching logic block in each die is configured to control data exchange of the die, and a line logic block in each die is configured to control data receiving and sending of the die. For example, the first logic block (for example, 1-21 and 2-21) is the switching logic block, and the second logic block (for example, 1-22 and 2-22) is the line logic block; or the first logic block (for example, 1-21 and 2-21) is the line logic block, and the second logic block (for example, 1-22 and 2-22) is the switching logic block.

Each of the plurality of dies may also be referred to as a bare die or a die, and the die may be obtained by cutting a wafer (wafer). Optionally, the die may be any die that has at least two types of interfaces and that has a problem of bus crossing when being connected to a board. In this specification, an example in which the die has two types of interfaces is used for description. The first interfaces (for example, 1-13 and 2-23) and the second interfaces (for example, 1-24 and 2-24) may be two types of interfaces of the die. The two types of interfaces may be located on a same side of the die, or may be located on different sides of the die. The die may include one or more first interfaces, and may further include one or more second interfaces. This is not specifically limited in embodiments of this application. In a possible example, the die may be an NP die (or referred to as an NP die), and two types of interfaces of the NP die may include a line side interface and a fabric side interface.

In addition, the switching logic block is configured to control data exchange of the die. In other words, the switching logic block is configured to control a data exchange path during data exchange of the die 2, for example, control data exchange between the die and a switching unit (switching unit, SWU). The switching logic block may be specifically connected to one or more interfaces of the die. When the switching logic block is connected to the one or more interfaces, the one or more interfaces may be referred to as fabric side interfaces (which may be specifically configured to connect to the switching unit), and the switching logic block may control data of the die to be exchanged to the corresponding fabric side interface.

The line logic block is configured to control data receiving and sending of the die. The data receiving may be receiving data from an optical module, and the data sending may be sending data to the optical module. To be specific, the switching logic block is configured to control the die to receive the data from the optical module and send the data to the optical module. The line logic block may be specifically connected to one or more interfaces of the die. When the line logic block is connected to the one or more interfaces, the one or more interfaces may be referred to as line side interfaces (which may be specifically configured to connect to the optical module), and the line logic block 22 may control the die to send and receive data through the line side interface.

In a possible embodiment, if the first logic block (for example, 1-21 and 2-21) is the switching logic block, and the second logic block (for example, 1-22 and 2-22) is the line logic block, the first interface 2-23 and the second interface 2-24 of the second die D2 may be configured to connect to the switching unit (SWU), and the first interface 1-23 and the second interface 1-24 of the first die D1 may be configured to connect to the optical module. Alternatively, if the first logic block (for example, 1-21 and 2-21) is the line logic block, and the second logic block (for example, 1-22 and 2-22) is the switching logic block, the first interface 1-23 and the second interface 1-24 of the first die D1 may be configured to connect to the switching unit (SWU), and the first interface 2-23 and the second interface 2-24 of the second die D2 may be configured to connect to the optical module.

In this embodiment of this application, the first logic block 1-21 of the first die D1 may be connected to the second interface 2-24 of the second die D2 via the interposer 1, and the second logic block 2-22 of the second die D2 may be connected to the first interface 1-23 of the first die D1 via the interposer 1. That is, compared with the conventional technology, in this application, interfaces of different dies may be exchanged via the interposer 1, so that a problem of bus crossing in the conventional technology can be resolved when the communication chip is connected to the board. In addition, process requirements and costs of the interposer 1 are far lower than process requirements and costs of the die, so that an area, costs, and power consumption of the communication chip can be reduced when the bus crossing is implemented via the interposer 1.

Further, the first logic block 1-21 of the first die D1 may be further connected to the first interface 1-23 of the first die D1, and the second logic block 2-22 of the second die D2 may be further connected to the second interface 2-24 of the second die D2. For example, the first logic block 1-21 may be connected to the first interface 1-23 inside the first die D1, and the second logic block 2-22 may be connected to the second interface 2-24 inside the second die D2.

Specifically, the first logic block 1-21 of the first die D1 may be configured to control the first interface 1-23 of the first die D1, and the second logic block 2-22 of the second die D2 may be configured to control the second interface 2-24 of the second die D2; or the first logic block 1-21 of the first die D1 may be configured to control the second interface 2-24 of the second die D2, and the second logic block 2-22 of the second die D2 may be configured to control the first interface 1-23 of the first die D1.

In actual application, a first selector switch may be disposed in a connection of the first interface 1-23 of the first die D1, a fastening end of the first selector switch is connected to the first interface 1-31, and two selection ends of the first selector switch may be respectively connected to the first logic block 1-21 of the first die D1 and the second logic block 2-22 of the second die D2. In this way, a logic block that controls the first interface 1-31 can be configured by configuring the two selection ends of the first selector switch. Similarly, a second selector switch may be disposed in a connection of the second interface 2-24 of the second die D2, a fastening end of the second selector switch is connected to the second interface 2-24, and two selection ends of the second selector switch may be respectively connected to the first logic block 1-21 of the first die D1 and the second logic block 2-22 of the second die D2. In this way, a logic block that controls the second interface 2-24 can be configured by configuring the two selection ends of the second selector switch.

In this embodiment of this application, two connection paths are disposed for each of the first interface 1-23 and the second interface 2-24, so that the logic blocks that control the interfaces can be properly configured based on locations of the first interface 1-23 and the second interface 2-24 in a case in which the communication chip is connected to the board. In this way, a problem of bus crossing does not exist when the communication chip is connected to a line side and a fabric side of the board.

In addition, the communication chip may include one or more first dies D1 and/or one or more second dies D2. The one or more first dies D1 and the one or more second dies D2 may be packaged through interconnection, to obtain the communication chip; or may be packaged with another die through interconnection, to obtain the communication chip. For any die in a same communication chip, connections corresponding to the first interface and the second interface of the die may be fastened, or are configurable. This is not specifically limited in embodiments of this application.

Further, in a possible embodiment, the interposer 1 may be an active interposer. In a possible example, the interposer 1 may include a redistribution layer (RDL), and the redistribution layer (RDL) includes an active component. The redistribution layer (RDL) and the active component may be configured to implement the foregoing connection, for example, configured to implement the connection between the first logic block 1-21 and the second interface 2-24, and the connection between the second logic block 2-22 and the first interface 1-23.

Optionally, the active component may include but is not limited to a register, a multiplexer MUX, a NAND gate NAND, a NOT gate NOR, and the like. When the interposer 1 is the active interposer, the foregoing connection may be implemented via the active component and the redistribution layer (RDL) in the active interposer, and the active component may be configured to enhance performance of a data signal transmitted in the foregoing connection, to dispose a long-distance connection trace.

Further, in another possible embodiment, the interposer 1 may be a passive interposer. In a possible example, the first die D1 and/or the second die D2 further include/includes an active component, the interposer 1 may include a redistribution layer (RDL), and the active component and the redistribution layer (RDL) may be configured to implement the foregoing connection. For example, the active component and the redistribution layer (RDL) may be configured to implement the connection between the first logic block 1-21 and the second interface 2-24, and the connection between the second logic block 2-22 and the first interface 1-23.

Optionally, the active component may include but is not limited to a register, a multiplexer MUX, a NAND gate NAND, a NOT gate NOR, and the like. When the interposer 1 is the passive interposer, the foregoing connection may be implemented via the active component in the first die D1 and/or the second die D2 and the redistribution layer (RDL) in the passive interposer, and the active component may be configured to enhance performance of a data signal transmitted in the foregoing connection, to dispose a long-distance connection trace.

Optionally, the communication chip may further include a substrate, and the interposer 1 is integrated on the substrate in an embedded (embedded) manner. When the interposer 1 is integrated on the substrate in the embedded manner, the interposer 1 and the substrate may be collectively referred to as an embedded bridge (embedded bridge).

Further, the interposer 1 may be of a one-layer or multi-layer structure. When the interposer 1 is of the multi-layer structure, a plurality of layers in the multi-layer structure may be configured to implement the foregoing connection. It may be understood that detailed descriptions of implementing the connection between the logic block and the interface of the first die D1 and the connection between the logic block and the interface of the second die D2 via the multi-layer structure are similar to the descriptions of implementing the connection between the logic block and the interface in the embodiment corresponding to the foregoing integrated apparatus. For specific descriptions, refer to related descriptions in the embodiment corresponding to the foregoing integrated apparatus. Details are not described herein again in embodiments of this application.

When the interposer 1 is the active interposer or the passive interposer, the interposer 1 is integrated on the substrate in the embedded manner, and the interposer 1 is of the multi-layer structure, the diagram of the structure corresponding to the communication chip is similar to the corresponding diagram in the foregoing embodiment of the integrated apparatus. For details, refer to the foregoing illustration. Details are not described herein again in embodiments of this application.

For ease of understanding, the following describes several possible structures of the communication chip by using examples.

In a possible example, the communication chip may include two dies (represented as D01 and D02), and each die may include an L interface and an F interface that are disposed on two adjacent sides. When a solution in the conventional technology is used, the communication chip formed by packaging the two dies through rotation is shown in (a) in FIG. 16. When the technical solution in this embodiment of this application is used, an F interface of a first die D01 may be exchanged with an L interface of a second die D02. After the exchange, the communication chip formed by packaging the two dies through rotation is shown in (b) in FIG. 16.

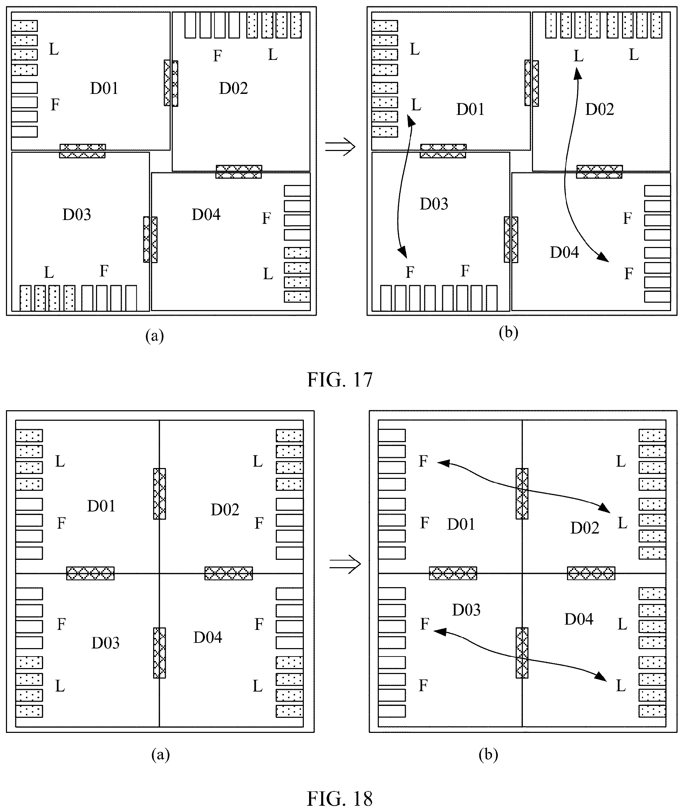

In another possible example, the communication chip may include four dies (represented as D01 to D04), and each die may include an L interface and an F interface that are disposed on a same side. When a solution in the conventional technology is used, the communication chip formed by packaging the four dies through rotation is shown in (a) in FIG. 17. When the technical solution in this embodiment of this application is used, in the four dies, an F interface of a first die D01 may be exchanged with an L interface of a third die D03, and an F interface of a second die D02 may be exchanged with an L interface of a fourth die D04. After the exchange, the communication chip formed by packaging the four dies through rotation is shown in (b) in FIG. 17.

In still another possible example, the communication chip may include four dies (represented as D01 to D04), and each die may include an L interface and an F interface that are disposed on a same side. When a solution in the conventional technology is used, the communication chip formed by packaging the four dies through symmetrization is shown in (a) in FIG. 18. When the technical solution in this embodiment of this application is used, in the four dies, an L interface of a first die D01 may be exchanged with an F interface of a second die D02, and an L interface of a third die D03 may be exchanged with an F interface of a fourth die D04. After the exchange, the communication chip formed by packaging the four dies through symmetrization is shown in (b) in FIG. 18.

In the communication chip provided in this embodiment of this application, interfaces of different dies in the communication chip may be exchanged via the interposer 1, to resolve a problem of bus crossing existing when the communication chip is connected to the board in the conventional technology. In addition, process requirements and costs of the interposer 1 are far lower than process requirements and costs of the die, so that an area, costs, and power consumption of the communication chip can be reduced when the bus crossing is implemented via the interposer 1.

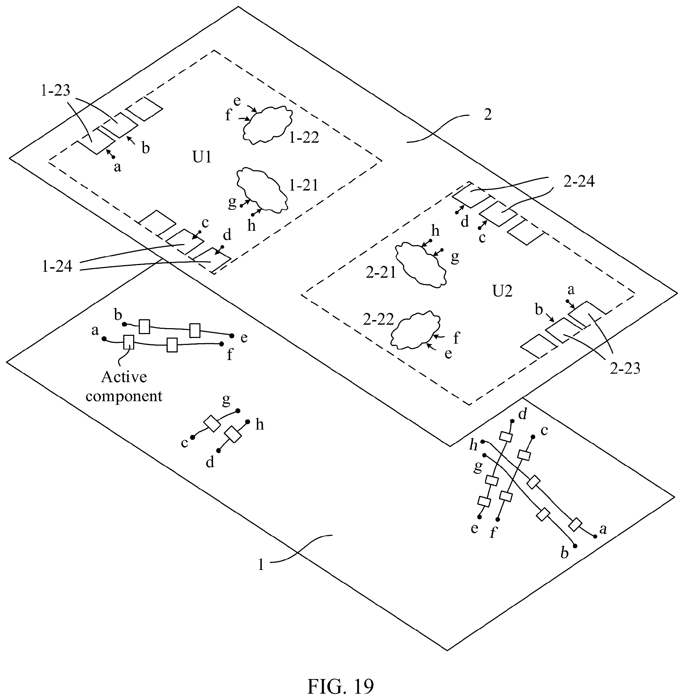

FIG. 19 is a diagram of another structure of an integrated apparatus according to an embodiment of this application. The integrated apparatus includes an interposer 1 and a die 2 located on the interposer 1. The die 2 may include a first unit U1 and a second unit U2 that are homogeneous. The foregoing unit may also be referred to as a module. In an example, the die 2 may be an NP die, and the foregoing unit may be a traffic manager (traffic manager, TM).

The first unit U1 includes a first logic block 1-21 and a first interface 1-23, and the second unit U2 includes a second logic block 2-22 and a second interface 2-24. The first logic block 1-21 of the first unit U1 is connected to the second interface 2-24 of the second unit U2 via the interposer 1, and the second logic block 2-22 of the second unit U2 is connected to the first interface 1-23 of the first unit U1 via the interposer 1.

Optionally, the first unit U1 further includes a second logic block 1-22 and a second interface 1-24 that are connected to each other, and the second unit U2 further includes a first logic block 2-21 and a first interface 2-23 that are connected to each other.

In an example, the second logic block 1-22 may be connected to the second interface 1-24 inside the first unit U1, and the first logic block 2-21 may be connected to the first interface 2-23 inside the second unit U2. In another example, the second logic block 1-22 may alternatively be connected to the second interface 1-24 via the interposer 1, and the first logic block 2-21 may alternatively be connected to the first interface 2-23 via the interposer 1.

The first logic block (for example, 1-21 and 2-21) is one of a switching logic block and a line logic block, and the second logic block (for example, 1-22 and 2-22) is the other of the switching logic block and the line logic block; and a switching logic block in each unit is configured to control data exchange of the unit, and a line logic block in each unit is configured to control data receiving and sending of the unit. For example, the first logic block (for example, 1-21 and 2-21) is the switching logic block, and the second logic block (for example, 1-22 and 2-22) is the line logic block; or the first logic block (for example, 1-21 and 2-21) is the line logic block, and the second logic block (for example, 1-22 and 2-22) is the switching logic block.

Optionally, each unit in the die 2 may be a unit that has at least two types of interfaces and that has a problem of bus crossing when being connected to a board. In this specification, an example in which the unit has two types of interfaces is used for description. The first interfaces (for example, 1-13 and 2-23) and the second interfaces 24 (for example, 1-24 and 2-24) may be two types of interfaces of the unit. The two types of interfaces may be located on a same side of the unit, or may be located on different sides of the unit. The unit may include one or more first interfaces, and may further include one or more second interfaces. This is not specifically limited in embodiments of this application. In a possible example, the two types of interfaces may include a line side interface and a fabric side interface.

In addition, the switching logic block is configured to control data exchange of the control unit. In other words, the switching logic block is configured to control a data exchange path during data exchange of the unit. The line logic block is configured to control data receiving and sending of the unit. The data receiving may be receiving data from an optical module, and the data sending may be sending data to the optical module.

In a possible embodiment, if the first logic block (for example, 1-21 and 2-21) is the switching logic block, and the second logic block (for example, 1-22 and 2-22) is the line logic block, the first interface 2-23 and the second interface 2-24 of the second unit U2 may be configured to connect to a switching unit (SWU), and the first interface 1-23 and the second interface 1-24 of the first unit U1 may be configured to connect to the optical module. Alternatively, if the first logic block (for example, 1-21 and 2-21) is the line logic block, and the second logic block (for example, 1-22 and 2-22) is the switching logic block, the first interface 1-23 and the second interface 1-24 of the first unit U1 may be configured to connect to a switching unit (SWU), and the first interface 2-23 and the second interface 2-24 of the second unit U2 may be configured to connect to the optical module.

In this embodiment of this application, the first logic block 1-21 of the first unit U1 may be connected to the second interface 2-24 of the second unit U2 via the interposer 1, and the second logic block 2-22 of the second unit U2 may be connected to the first interface 1-23 of the first unit U1 via the interposer 1. That is, compared with the conventional technology, in this application, interfaces of different units in a same die may be exchanged via the interposer 1, so that a problem of bus crossing in the conventional technology can be resolved when the die is connected to the board. In addition, process requirements and costs of the interposer 1 are far lower than process requirements and costs of the die, so that an area, costs, and power consumption of the die can be reduced when the bus crossing is implemented via the interposer 1.

Further, the first logic block 1-21 of the first unit U1 may be further connected to the first interface 1-23 of the first unit U1, and the second logic block 2-22 of the second unit U2 may be further connected to the second interface 2-24 of the second unit U2. For example, the first logic block 1-21 may be connected to the first interface 1-23 inside the first unit U1, and the second logic block 2-22 may be connected to the second interface 2-24 inside the second unit U2.

Specifically, the first logic block 1-21 of the first unit U1 may be configured to control the first interface 1-23 of the first unit U1, and the second logic block 2-22 of the second unit U2 may be configured to control the second interface 2-24 of the second unit U2; or the first logic block 1-21 of the first unit U1 may be configured to control the second interface 2-24 of the second unit U2, and the second logic block 2-22 of the second unit U2 may be configured to control the first interface 1-23 of the first unit U1.

In actual application, a first selector switch may be disposed in a connection of the first interface 1-31 of the first unit U1, a fastening end of the first selector switch is connected to the first interface 1-31, and two selection ends of the first selector switch may be respectively connected to the first logic block 1-21 of the first unit U1 and the second logic block 2-22 of the second unit U2. In this way, a logic block that controls the first interface 1-31 can be configured by configuring the two selection ends of the first selector switch. Similarly, a second selector switch may be disposed in a connection of the second interface 2-24 of the second unit U2, a fastening end of the second selector switch is connected to the second interface 2-24, and two selection ends of the second selector switch may be respectively connected to the first logic block 1-21 of the first unit U1 and the second logic block 2-22 of the second unit U2. In this way, a logic block that controls the second interface 2-24 can be configured by configuring the two selection ends of the second selector switch.

In this embodiment of this application, two connection paths are disposed for each of the first interface 1-23 and the second interface 2-24, so that the logic blocks that control the interfaces can be properly configured based on locations of the first interface 1-23 and the second interface 2-24 in a case in which the die is connected to the board. In this way, a problem of bus crossing does not exist when the die is connected to a line side and a fabric side of the board.

In addition, the die may include one or more first units U1 and/or one or more second units U2. The one or more first units U1 and the one or more second units U2 may be packaged through interconnection, to obtain the die; or may be packaged with another unit through interconnection, to obtain the die. For any unit in a same die, connections corresponding to the first interface and the second interface of the unit may be fastened, or are configurable. This is not specifically limited in embodiments of this application.

Further, in a possible embodiment, the interposer 1 may be an active interposer. In a possible example, the interposer 1 may include a redistribution layer (RDL), and the redistribution layer (RDL) includes an active component. The redistribution layer (RDL) and the active component may be configured to implement the foregoing connection, for example, configured to implement the connection between the first logic block 1-21 and the second interface 2-24, and the connection between the second logic block 2-22 and the first interface 1-23.

Optionally, the active component may include but is not limited to a register, a multiplexer MUX, a NAND gate NAND, a NOT gate NOR, and the like. When the interposer 1 is the active interposer, the foregoing connection may be implemented via the active component and the redistribution layer (RDL) in the active interposer, and the active component may be configured to enhance performance of a data signal transmitted in the foregoing connection, to dispose a long-distance connection trace.

Further, in another possible embodiment, the interposer 1 may be a passive interposer. In a possible example, the first unit U1 and/or the second unit U2 further include/includes an active component, the interposer 1 may include a redistribution layer (RDL), and the active component and the redistribution layer (RDL) may be configured to implement the foregoing connection. For example, the active component and the redistribution layer (RDL) may be configured to implement the connection between the first logic block 1-21 and the second interface 2-24, and the connection between the second logic block 2-22 and the first interface 1-23.

Optionally, the active component may include but is not limited to a register, a multiplexer MUX, a NAND gate NAND, a NOT gate NOR, and the like. When the interposer 1 is the passive interposer, the foregoing connection may be implemented via the active component in the first unit U1 and/or the second unit U2 and the redistribution layer (RDL) in the passive interposer, and the active component may be configured to enhance performance of a data signal transmitted in the foregoing connection, to dispose a long-distance connection trace.

Optionally, the integrated apparatus may further include a substrate, and the interposer 1 is integrated on the substrate in an embedded (embedded) manner. When the interposer 1 is integrated on the substrate in the embedded manner, the interposer 1 and the substrate may be collectively referred to as an embedded bridge (embedded bridge).

Further, the interposer 1 may be of a one-layer or multi-layer structure. When the interposer 1 is of the multi-layer structure, a plurality of layers in the multi-layer structure may be configured to implement the foregoing connection. It may be understood that detailed descriptions of implementing the connection between the logic block and the interface of the first unit U1 and the connection between the logic block and the interface of the second unit U2 via the multi-layer structure are similar to the descriptions of implementing the connection between the logic block and the interface in the embodiment corresponding to the foregoing communication chip. For specific descriptions, refer to related descriptions in the embodiment corresponding to the foregoing integrated apparatus. Details are not described herein again in embodiments of this application.

When the interposer 1 is the active interposer or the passive interposer, the interposer 1 is integrated on the substrate in the embedded manner, and the interposer 1 is of the multi-layer structure, the diagram of the structure corresponding to the integrated apparatus is similar to the corresponding diagram in the foregoing embodiment of the integrated apparatus. For details, refer to the foregoing illustration. Details are not described herein again in embodiments of this application.

Further, when the die 2 includes a plurality of homogeneous units, interfaces may be exchanged between any two of the plurality of units, and different interfaces of a same unit may also be exchanged. A specific exchange manner is similar to manners of exchanging different interfaces of the integrated apparatus corresponding to FIG. 6 to FIG. 11. For details, refer to the foregoing related descriptions. Details are not described herein again in embodiments of this application.

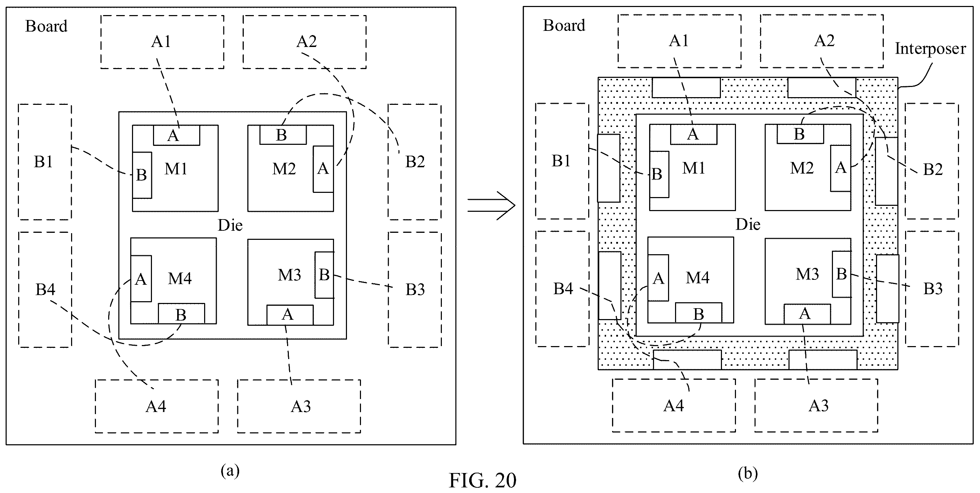

For ease of understanding, the following describes a structure of the integrated apparatus by using (a) and (b) in FIG. 20 as examples. The die may include four units (represented as M1 to M4), and each unit may include an A interface and a B interface that are disposed on two adjacent sides. When a solution in the conventional technology is used, the integrated apparatus formed by packaging the four units through rotation is shown in (a) in FIG. 20. When the technical solution in this embodiment of this application is used, in the four units, an A interface and a B interface of a second unit M2 may be exchanged, and an A interface and a B interface of a third unit M3 may be exchanged. After the exchange, the integrated apparatus formed by packaging the four units through rotation is shown in (b) in FIG. 20. FIG. 20 further shows the interposer and the board of the integrated apparatus, and pins that are on the board and that are configured to connect to interfaces, where the pins may include A1 to A4 and B1 to B4.

In the integrated apparatus provided in this embodiment of this application, interfaces of different units in the die may be exchanged via the interposer 1, to resolve a problem of bus crossing existing when the die is connected to the board in the conventional technology. In addition, process requirements and costs of the interposer 1 are far lower than process requirements and costs of the die, so that an area, costs, and power consumption of the die can be reduced when the bus crossing is implemented via the interposer 1.

In view of this, an embodiment of this application further provides a communication chip. The communication chip includes one or more integrated apparatuses provided in the embodiment corresponding to FIG. 19 and FIG. 20. The foregoing detailed descriptions of the integrated apparatus may be correspondingly cited in the embodiment corresponding to the communication chip. Details are not described herein again in embodiments of this application.

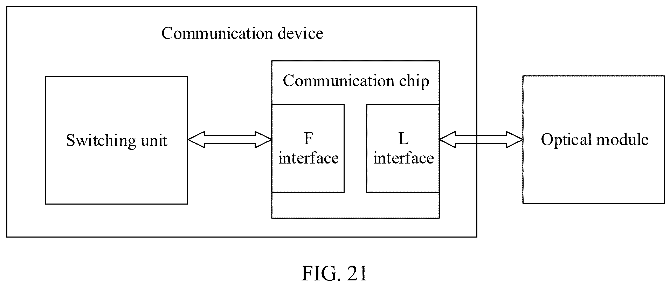

In view of this, as shown in FIG. 21, an embodiment of this application further provides a communication device. The communication device may include a switching unit and a line processing unit connected to the switching unit. The line processing unit includes any communication chip provided above. A corresponding fabric side interface of the line processing unit may be specifically connected to the switching unit, and a corresponding line side interface of the line processing unit may be specifically connected to an optical module. Optionally, the communication device may be a router or a switch. For example, the switch may be a modular switch.

It may be understood that the foregoing detailed descriptions of the integrated apparatus and the communication chip may be correspondingly cited in the embodiment corresponding to the communication device. Details are not described herein again in embodiments of this application.

It should be finally noted that foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated apparatus, wherein the integrated apparatus comprises an interposer and a die located on the interposer;
the die comprises a switching logic block, a line logic block, a first interface, and a second interface, the switching logic block is configured to control data exchange of the die, and the line logic block is configured to control data receiving and sending of the die; and
the switching logic block is connected to the first interface via the interposer, and the line logic block is connected to the second interface via the interposer.

2. The integrated apparatus according to claim 1, wherein the switching logic block is configured to exchange data through the first interface; and
the line logic block is configured to receive and send data through the second interface.

3. The integrated apparatus according to claim 1 or 2, wherein the first interface is configured to connect to a switching unit, and the second interface is configured to connect to an optical transport unit.

4. The integrated apparatus according to any one of claims 1 to 3, wherein the switching logic block is further connected to the second interface via the interposer, and the line logic block is further connected to the first interface via the interposer.

5. The integrated apparatus according to any one of claims 1 to 4, wherein the interposer comprises a redistribution layer, and the redistribution layer is configured to connect the switching logic block and the line logic block to the first interface and the second interface.

6. The integrated apparatus according to claim 5, wherein the die further comprises an active component, and the active component is further configured to connect the switching logic block and the line logic block to the first interface and the second interface;
or
the redistribution layer comprises an active component, and the active component is further configured to connect the switching logic block and the line logic block to the first interface and the second interface.

7. The integrated apparatus according to any one of claims 1 to 6, wherein the integrated apparatus further comprises a substrate, and the interposer is integrated on the substrate in an embedded manner.

8. The integrated apparatus according to any one of claims 1 to 7, wherein the interposer is of a multi-layer structure.

9. A communication chip, wherein the communication chip comprises the integrated apparatus according to any one of claims 1 to 8.

10. A communication chip, wherein the communication chip comprises an interposer and a plurality of dies located on the interposer, and the plurality of dies comprise a first die and a second die;
the first die comprises a first logic block and a first interface, the second die comprises a second logic block and a second interface, the first logic block of the first die is connected to the second interface of the second die via the interposer, and the second logic block of the second die is connected to the first interface of the first die via the interposer; and
the first logic block is one of a switching logic block and a line logic block, and the second logic block is the other of the switching logic block and the line logic block; and a switching logic block in each die is configured to control data exchange of the die, and a line logic block in each die is configured to control data receiving and sending of the die.

11. The communication chip according to claim 10, wherein the first die further comprises a second logic block and a second interface that are connected to each other, and the second die further comprises a first logic block and a first interface that are connected to each other.

12. The communication chip according to claim 11, wherein if the first logic block is the switching logic block, the first interface and the second interface of the second die are configured to connect to a switching unit, and the first interface and the second interface of the first die are configured to connect to an optical transport unit; or
if the second logic block is the switching logic block, the first interface and the second interface of the first die are configured to connect to a switching unit and the first interface and the second interface of the second die are configured to connect to an optical transport unit.

13. The communication chip according to any one of claims 10 to 12, wherein the interposer comprises a redistribution layer, and the redistribution layer is configured to connect the first logic block of the first die to the second interface of the second die and connect the second logic block of the second die to the first interface of the first die.

14. The communication chip according to claim 13, wherein the first die and the second die further comprise active components, and the active components are further configured to connect the first logic block of the first die to the second interface of the second die and connect the second logic block of the second die to the first interface of the first die;
or
the redistribution layer comprises an active component, and the active component is further configured to connect the first logic block of the first die to the second interface of the second die and connect the second logic block of the second die to the first interface of the first die.

15. The communication chip according to any one of claims 10 to 14, wherein the communication chip further comprises a substrate, and the interposer is integrated on the substrate in an embedded manner.

16. The communication chip according to any one of claims 10 to 15, wherein the interposer is of a multi-layer structure.

17. A communication device, wherein the communication device comprises a switching unit and a line processing unit connected to the switching unit, and the line processing unit comprises the communication chip according to any one of claims 9 to 16.

18. An integrated apparatus, wherein the integrated apparatus comprises an interposer and a die located on the interposer;
the die comprises a first unit and a second unit, the first unit comprises a first logic block and a first interface, the second unit comprises a second logic block and a second interface, the first logic block of the first unit is connected to the second interface of the second unit via the interposer, and the second logic block of the second unit is connected to the first interface of the first unit via the interposer; and
the first logic block is one of a switching logic block and a line logic block, and the second logic block is the other of the switching logic block and the line logic block; and a switching logic block in each unit is configured to control data exchange of the unit, and a line logic block in each unit is configured to control data receiving and sending of the unit.

19. The integrated apparatus according to claim 18, wherein the first unit further comprises a second logic block and a second interface that are connected to each other, and the second unit further comprises a first logic block and a first interface that are connected to each other.

20. The integrated apparatus according to claim 19, wherein if the first logic block is the switching logic block, the first interface and the second interface of the second unit are configured to connect to a switching unit; or
if the second logic block is the switching logic block, the first interface and the second interface of the first unit are configured to connect to a switching unit.

21. The integrated apparatus according to any one of claims 18 to 20, wherein the interposer comprises a redistribution layer, and the redistribution layer is configured to connect the first logic block of the first unit to the second interface of the second unit and connect the second logic block of the second unit to the first interface of the first unit.

22. The integrated apparatus according to claim 21, wherein the first unit and the second unit further comprise active components, and the active components are further configured to connect the first logic block of the first unit to the second interface of the second unit and connect the second logic block of the second unit to the first interface of the first unit;
or
the redistribution layer comprises an active component, and the active component is further configured to connect the first logic block of the first unit to the second interface of the second unit and connect the second logic block of the second unit to the first interface of the first unit.

23. The integrated apparatus according to any one of claims 18 to 22, wherein the integrated apparatus further comprises a substrate, and the interposer is integrated on the substrate in an embedded manner.

24. The integrated apparatus according to any one of claims 18 to 23, wherein the interposer is of a multi-layer structure.
